# EUROPEAN PATENT SPECIFICATION

(11) **EP 3 693 168 B1**
(45) Date of publication and mention of the grant of the patent: **14.05.2025**
(21) Application number: 19211340.5
(22) Date of filing: 26.11.2019
(51) Int. Cl.: B41F 15/08, B41F 15/20, B41F 15/26, B41F 33/00, H01L 21/68, H05K 3/12

(54) **ALIGNMENT OF SINGLE WORKPIECES AND METHOD**
AUSRICHTUNG VON VEREINZELTEN WERKSTÜCKEN UND VERFAHREN
ALIGNEMENT DE PIÈCES SÉPARÉES ET PROCÉDÉ

(30) Priority: 03.01.2019 GB 201900058
(43) Date of publication of application: 12.08.2020
(73) Proprietor: ASMPT SMT Singapore Pte. Ltd., Singapore 768924 (SG)
(72) Inventor: Foggie, David Andrew, Dorchester, Dorset DT2 9LH (GB); Pape, Simon Stuart, Yeovil, Somerset BA20 1SE (GB); Gaukroger, David Alexander, Dorchester, Dorset DT2 9LQ (GB)
(74) Representative: Emerson, Peter James

(56) References cited:
- WO-A1-2014/083605
- GB-A- 2 559 982
- JP-A- 2000 037 846
- JP-A- H0 557 874
- US-A- 6 048 750

## Description

This invention relates to a workpiece support assembly, a printing machine, and a method of printing onto a plurality of singulated workpieces.

### Background and Prior Art

Industrial screen-printing machines typically apply a conductive print medium, such as solder paste or conductive ink, onto a planar workpiece, such as a circuit board, by applying the conductive print medium through a pattern of apertures in a screen (sometimes referred to as a foil or stencil) using an angled blade or squeegee. Where the area of the pattern is relatively small with respect to the area of the screen, it is possible to include more than one pattern within the screen, thus allowing more than one area of a board, or more than one board, to be printed simultaneously using the same screen. Alternatively, more than one relatively small screen may be used within the same printing machine to enable the more than one area of a board, or more than one board, to be printed simultaneously using respective screens. While such simultaneous printing may clearly be more efficient than sequential printing, there are problems associated with these techniques.

### i) Printing of more than one area of a board

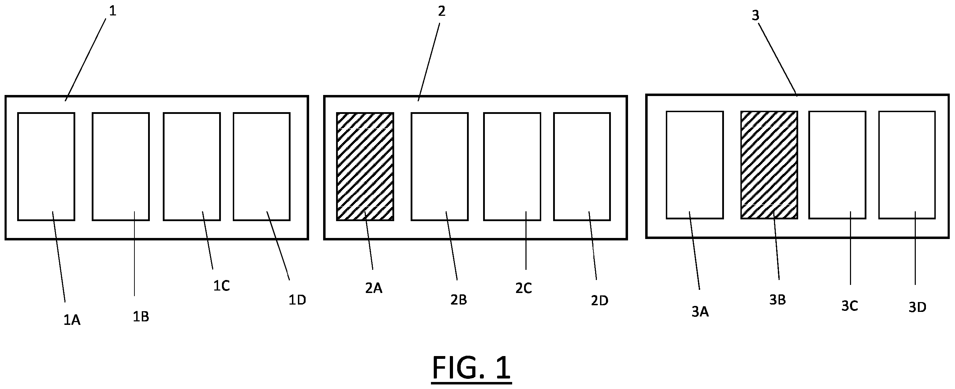

As noted above, it is possible to print a plurality or array of patterns onto respective areas of a single board or panel in a single print operation, to produce a plurality of printed circuit boards (PCBs) which may be subsequently physically separated. This technique is conceptually and technically simple - a panel with a plurality of boards is loaded into a printing machine, correctly aligned and then all the boards of the panel are printed simultaneously. However, with any circuit board there is a risk that at least part of that board may be defective, which in turn may lead to a defective PCB. This situation is schematically shown in FIG. 1, where three panels 1, 2, 3 are shown, each having a 4x1 array of boards A-D. While the left-most panel 1 is completely free from defects, the adjacent panel 2 has a defective board 2A, while the right-most panel 3 has a defective board 3B. It is inefficient to pre-check the circuit boards for defects and reject an entire panel if one board is found to be defective. It is also inefficient and problematic to print a pattern onto an identified defective board and reject the separated defective board subsequent to the printing process. One current solution to this problem is to identify defective boards before commencement of the printing operation, and sort the panels into separate batches having similar defects, for example a first batch which is defect-free, a second batch in which the left-most board is defective, a third batch in which the second-left board is defective and so on. A dedicated respective screen may then be used with each batch. For example, a screen having all four aperture patterns would be used for the first batch, while screens having only three aperture patterns would be used for each remaining batch. For the 4×1 array described here, this would result in the use of five different screens per panel to print on a side of the panel. Since each panel will typically be printed on both sides, this could lead to the use of ten different set-ups for a single panel type, rather than the optimal two (i.e. one for each side). In addition, the second to fifth batches will only be printing at 75% efficiency. Furthermore, if two or more boards are defective then additional measures must be taken.

### ii) Printing of more than one board

A solution to the above problem is to pre-separate or "singulate" the individual boards before the printing process. Here, any defective boards could be identified before printing and rejected immediately, so that only non-defective boards are printed. While this process is relatively efficient, it introduces complications. In particular, it is difficult both to support and to align individual relatively small boards for simultaneous (or sequential) printing.

Various approaches have been developed to overcome these problems. For example, GB 2484373 A describes a method in which individual boards are respectively positioned, but this only permits the sequential printing of one substrate at a time. JP-2009-248551 describes a method in which the position of each board is checked individually, and each board is sequentially repositioned using a repositioning arm. This technique does permit all boards of a panel to be printed in simultaneously, but the sequential repositioning is time-consuming and the positioning arm apparatus takes up useful space within the printing machine. WO2014/166956 describes an alternative apparatus, in which all boards may be aligned simultaneously using a reference webbing, and then simultaneously printed. This solution works well, though will not be suitable if an incoming unprinted board is positioned too far from its correct position.

WO2014/083605 A1 describes a workpiece support assembly having the precharacterising features of claim 1. Similarly to WO2014/166956, a separate reference webbing is used to simultaneously align the supported workpieces.

The present invention seeks to overcome these problems and provide apparatus and methodology for printing a plurality of singulated workpieces, such as circuit boards, in a single printing operation. Advantageously, the present invention enables simultaneous alignment of the workpieces while maintaining high levels of flexibility in the printing process. The simultaneous vision alignment enabled by the present invention will maintain or increase alignment accuracy whilst increasing throughput. Furthermore, the proposed apparatus is compact, particularly being of relatively low height and may be retrofitted to existing printing machines. Other advantages include the ease of providing vacuum supply to clamp workpieces thereon, and the small number of moving parts.

In accordance with the present invention this aim is achieved by providing support towers for individual workpieces, each tower individually capable of adjusting the position and orientation of a workpiece supported thereon so that each workpiece may have a unique alignment position.

### Summary of the Invention

In accordance with a first aspect of the present invention there is provided a workpiece support assembly for supporting and aligning a plurality of singulated workpieces in a printing operation, the workpiece support assembly comprising an assembly body and a plurality of support members mounted on the assembly body which each support a workpiece in use, each support member comprising:
a base mounted on the assembly body, and
a head unit for supporting a workpiece thereon,
characterised in that each support member further comprises an actuation mechanism for moving the head unit relative to the base,
wherein the actuation mechanism comprises a parallel kinematic system having at least three drive units each directly acting on the head unit, such that the actuation mechanism is selectively operative to move the head unit relative to the base to cause a translation of the head unit parallel to a plane, a rotation of the head unit about an axis orthogonal to that plane, or a combination of said translation and said rotation.

In accordance with a second aspect of the present invention there is provided a printing machine comprising the workpiece support assembly of the first aspect.

In accordance with a third aspect of the present invention there is provided a method of printing a plurality of singulated workpieces, comprising the steps of:
providing the printing machine of the second aspect;
aligning the plurality of singulated workpieces using a method comprising the steps of:
   a) positioning the workpieces over the workpiece support assembly of the first aspect, such that each workpiece overlies a respective support member;
   b) lifting the workpiece support assembly so that the support members contact and lift the respective overlying workpieces; and
   c) aligning each workpiece individually by operation of the respective actuation mechanisms; and
performing a printing operation on the aligned workpieces.

Other specific aspects and features of the present invention are set out in the accompanying claims.

### Brief Description of the Drawings

The invention will now be described with reference to the accompanying drawings (not to scale), in which:
FIG. 1 schematically shows three panels, each holding four boards;
FIG. 2A schematically shows, in an exploded perspective view, a support member for a workpiece support assembly in accordance with an embodiment of the present invention;
FIG. 2B schematically shows, in an exploded perspective view, a tooling module and workpiece for fitting to the workpiece support assembly of FIG. 2A;
FIG. 2C schematically shows in a sectional perspective view, the fitted workpiece support assembly and tooling module of FIGs. 2A and 2B;
FIG. 3 schematically shows from above an actuation mechanism according to a second embodiment of the present invention;
FIG. 4 schematically shows, in perspective view, a lifting table of a printing machine fitted with a workpiece support assembly in accordance with an embodiment of the present invention, having a 4x1 array of workpiece support modules;
FIG. 5 schematically shows the lifting table of FIG. 4 with the surround plate omitted for clarity;
FIG. 6 schematically shows the lifting table of FIG. 5 with the carrier omitted for clarity;
FIGs. 7A-F schematically show, from above, stages in a printing process in accordance with the present invention, using the apparatus of FIG. 4;
FIG. 8 schematically shows, in perspective view, the lifting table of FIG. 4 fitted with a workpiece support assembly in accordance with an alternative embodiment of the present invention, having a 4x2 array of workpiece support modules;
FIG. 9 schematically shows, in perspective view, a workpiece support assembly in accordance with an alternative embodiment of the present invention;
FIG. 10 schematically shows, in perspective view, a composite control board for use with the workpiece support assembly of FIG. 9;
FIG. 11 schematically shows a hexapod-type actuation mechanism; and
FIG. 12 schematically shows, from above, an actuation mechanism in accordance with a further embodiment.

### Detailed Description of the Preferred Embodiments of the Invention

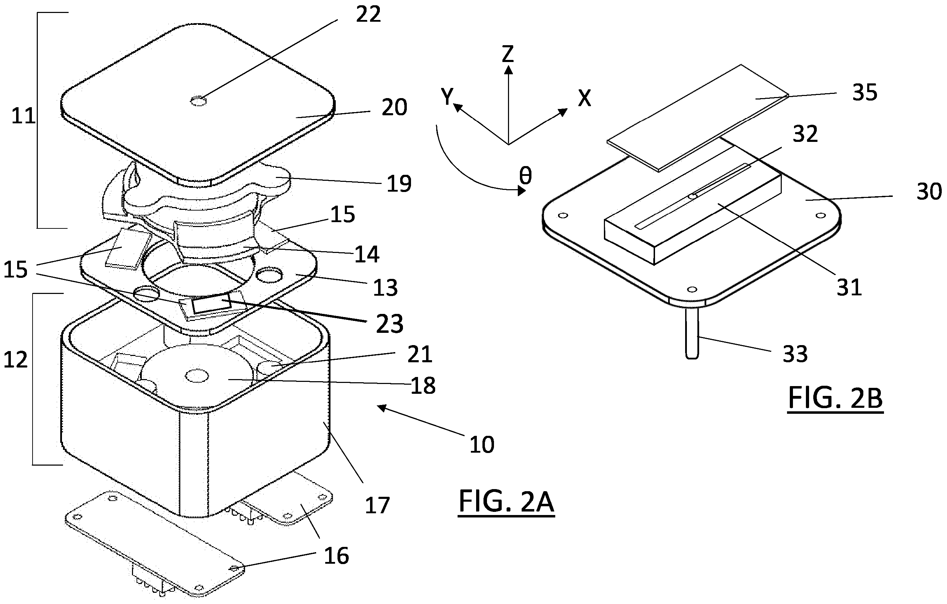

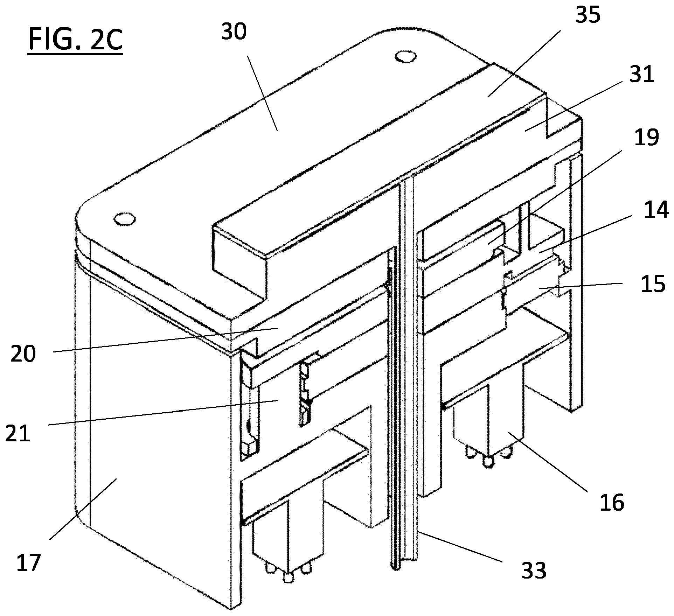

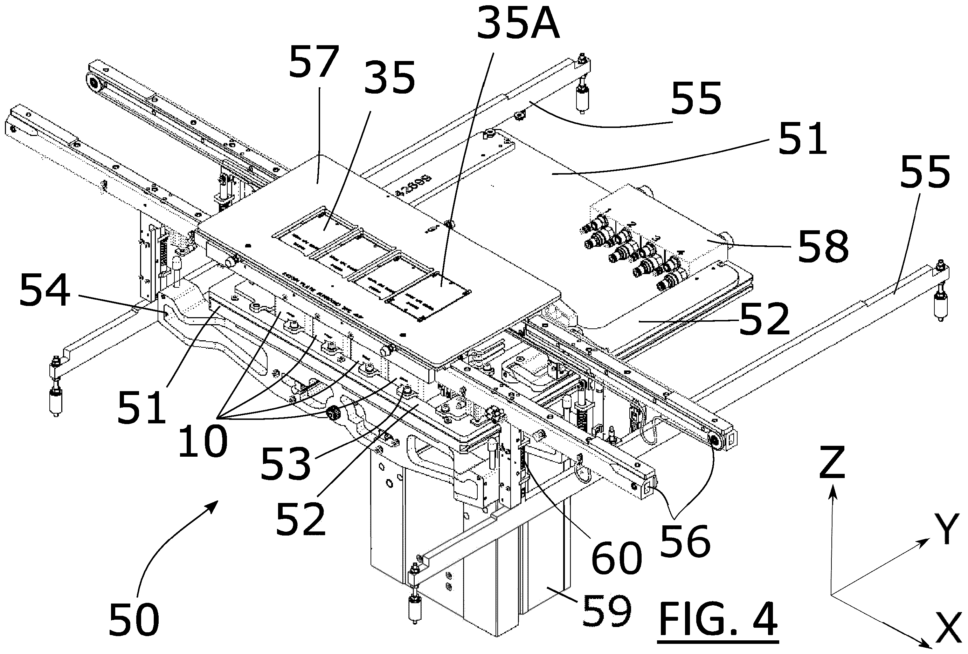

A support member 10 according to a first embodiment of the present invention is schematically shown in FIG. 2A, in an exploded perspective view. A tooling module 30 for use with support member 10 is schematically shown in exploded perspective view in FIG. 2B. Support member 10, with tooling module 30 attached is schematically shown in a perspective view in FIG. 2C. As can be seen in these figures, the support member 10 has a central axis parallel to the vertical in use, which in the art is generally referred to as the Z-axis. The support member 10 comprises two main sub-structures, a head unit 11 and a base 12. The head unit 11, which is located at the top of the support member 10 in use, is provided to support a workpiece thereon within an X-Y plane normal to the Z-axis, via a tooling module such as tooling module 30 shown in FIG. 2B, which may be connected to a tooling interface plate 20 at the top of the head unit 11. The base 12 comprises a housing 17 which is preferably mounted on a table (see for example FIG. 4) for reception into a printing machine (not shown), the table carrying a plurality of such support members in a parallel and spaced configuration, such that the support members cannot contact each other during operation. Each support member 10 of the plurality may support a respective singulated workpiece in use, as will be described in more detail subsequently. The support member 10 also comprises an actuation mechanism with a stator 13 and rotor 14, which is selectively operative to translate the head unit 11 parallel to the X-Y plane and / or to rotate the head unit 11 about an axis orthogonal to that plane, i.e. parallel to the Z-axis in the so-called θ direction. The stator 13, which is fixed to and within the base 12, comprises a printed circuit board (PCB) with a plurality of drive units each in the form of a coil, provided thereon. Here, three drive units each comprising an independently operable linear motor coil 15 are mounted on the PCB, with their coil axes located parallel to the X-Y plane and having non-parallel axes, here being equally distributed about the Z-axis, i.e. at 60° to each other.

The coils 15 are controlled via control boards 16 located at the bottom of base 12, which comprise a processor (not shown) connected for both power and communication with an external source (not shown). The rotor 14 comprises a magnet assembly which is driven by the coils 15 in use. As is generally known in the art, the arrangement of linear motor coils 15 enables the rotor 14 to be translated along the X or Y-axes, or in any combination of the two, by selectively operating the coils 15 to produce a suitable superposition of the electromotive forces generated thereby. Similarly, if all coils 15 are operated with equal power, the rotor 14 will be caused to rotate in the θ direction, i.e. parallel to the Z-axis. The rotor may also be simultaneously both translated and rotated by suitable control of the coils 15. It should be noted that such control may in other embodiments (not shown) also be achieved by using more than three coils. The accuracy of any such movement is controlled by providing at least one suitable encoder 23, here on the head unit 11, on the upper surface of a coil 15, which is associated with a graticule (not shown) on the underside of rotor 14. In other embodiments, at least one encoder may be provided on the base 12.

To facilitate relative movement of the rotor 14 and stator 13, a bearing, for example an air bearing 18 (most clearly visible in FIG. 2A), is located between the base 12 and the head unit 11. The rotor 14 engages the underside of the tooling interface plate 20 so that the tooling interface plate 20 moves with the rotor 14. A second bearing, for example an air bearing 19, is located between the rotor 14 and the tooling interface plate 20 while being supported by the base 12, and acts to support the tooling interface plate 20 in a low-friction manner. In more detail, and as more clearly shown in FIG. 2C, lugs of the air bearing 19 are supported by respective posts 21 which project upwardly from the base 12. It can be seen most clearly from FIG. 2C that the support member 10 is provided with a through-bore, extending substantially along the axis of the support member 10. An aperture 22 in the tooling interface plate 20 connects with the through-bore at one end, while a further aperture is at the distal end. This through-bore provides a vacuum path through the support member 10, as will be described in more detail below.

The support member 10 is "intelligent" in that it is also provided with its own processor (not shown), so that control of the actuation mechanism via the encoder is managed within the support member 10.

The tooling interface plate 20 is adapted to engage with a tooling module 30, most clearly shown in FIG. 2B, such that the tooling module 30 moves with the tooling interface plate 20. Advantageously, the tooling module 30 is a bespoke apparatus specifically tailored to a particular form of workpiece to be carried by the tooling module. The tooling module can be replaced by alternative modules to allow carrying of other workpieces. In alternative embodiments (not shown), the tooling module 30 may be integrally formed with the support member, in which case the tooling interface plate 20 may be omitted.

The tooling module 30 comprises a raised tooling chuck 31, on which a workpiece, such as a singulated workpiece 35 is supported in use. Preferably, the tooling chuck 31 is modular, so that it may be removed from the tooling module 30 or exchanged in a simple manner. In a preferred embodiment, the tooling chuck 31 is magnetically coupled with the tooling module 30, which arrangement removes the need for physical attachment means such as screws. At the upper surface of tooling chuck 31 is a vacuum engagement opening 32, which communicates with a vacuum channel 33 which extends downwardly from the tooling module 30. In use, and as shown in FIG. 2C, the vacuum channel 30 extends through the vacuum path of the support member 10. The distal end of the vacuum channel 33 acts as a port for connection to an external vacuum source. When connected and an at least partial vacuum is applied, the workpiece 35 is thereby secured onto the tooling chuck 31. It should be noted that if the dimensions of the path through the support member 10 are sufficiently large, then the vacuum channel 33 may be formed as a rigid pipe, for example a metallic or rigid plastics material, which will not be deformed during movement of the head unit 11. In an alternative embodiment, the vacuum channel 33 may be formed as a flexible tube, for example comprising a plastics material, which may be deformed during movement of the head unit 11 without suffering damage. In a yet further embodiment, the support member 10 may be provided with a vacuum channel permanently located within the path, and the tooling module is adapted to engage with the vacuum channel proximate the aperture 22.

It should be noted that the tooling module 30 shown is exemplary only, and may take a variety of shapes, profiles and sizes. In addition, the chuck may comprise a manifold, connected or connectable to the vacuum channel, for distributing the vacuum to various parts of the workpiece thereon. Furthermore, a vacuum sensing system may be provided, as is generally known in the art, to detect sub-optimal vacuum clamping of the workpiece.

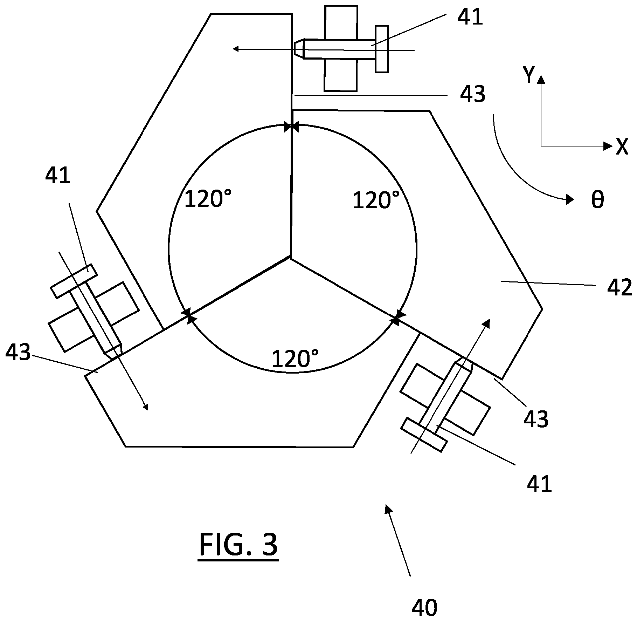

FIG. 3 schematically shows from above an actuation mechanism 40 according to a second embodiment of the present invention. Similarly to the actuation mechanism of FIG. 2, three individually operable drive units in the form of actuators 41 are used, which are linearly drivable along respective axes being equally distributed about the Z-axis, i.e. at 60° to each other. The actuators 41 act on a generally triangular rotor 42, with each acting on a surface 43 of the rotor orthogonal to the driving axis of the respective actuator 41. Each actuator is free to move relative to the respective surface 43 within the X-Y plane. As with the embodiment of FIG. 2, suitable operation of the three actuators 41 can cause the rotor 42 to translate, to rotate, or to both translate and rotate.

FIG. 4 schematically shows, in perspective view, a support apparatus 50 of a printing machine fitted with a workpiece support assembly in accordance with an embodiment of the present invention, having a 4x1 array of workpiece support members 10, each of which is similar to that shown in FIG. 2. For clarity, surrounding components of the printing machine have been omitted. Each support member 10 is shown as supporting a singulated workpiece 35. The most forward-located singulated workpiece 35A is shown in FIGs. 4 to 6 in a raised position for the purposes of illustration only - as will be described in more detail below, generally all workpieces 35 would be raised and lowered in concert. For convenience, FIG. 4 also shows a conventional co-ordinate system.

Each workpiece support member 10 is mounted an on assembly body, which as shown includes a table 51, on which the support members 10 are supported and optionally attached, and a reference plate 52 which is attached on top of the table 51, for example by screws. The reference plate 52 includes a central aperture which is configured to receive the array of support members 10, so that the support members 10 extend through the aperture of the reference plate 52. The support members 10 are attached, for example by screws, to the reference plate 52 at attachment points 53. In this way, the table 51 ensures that each support member 10 is located at the correct height (i.e. the correct Z-axis position), while the reference plate 52 ensures that the support members 10 are correctly positioned in the X-Y plane. To achieve this X-Y positioning, it will be understood that the aperture of the reference plate 52 should closely conform to the external surfaces of the support member array when in the desired location. In alternative embodiments, the reference plate 52 could for example include more than one aperture, for example one aperture per support member 10. The table 51 is supported by a two-part cradle structure 54. The two parts of the cradle structure 54 may be moved relative to each other in the Y-direction, for example by suitable manual rotation of a worm gear, so that the width of the cradle structure 54 may be adjusted, for example to accommodate differently-sized tables 51.

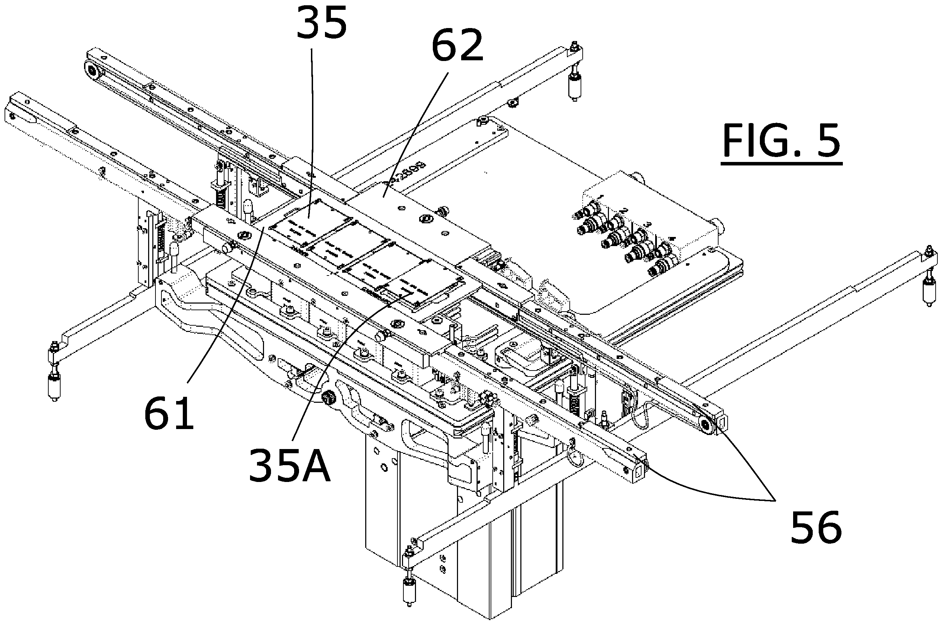

A pair of transport rails 56 is provided in the printing machine, which extend parallel to the X-axis. Each rail 56 comprises a conveyor belt or the like operative to transport workpieces 35 therebetween in the positive X direction as is generally known in the art. As will be more clearly shown in FIG. 5, the workpieces 35 are located in a carrier 61 which is directly transported by the rails 56. In more detail, the workpieces 35 are mounted on dowels (not visible in the figures) located within the carrier 61. The rails 56 are carried by a pair of elongate "clatter bars" 55 which extend parallel to the Y-axis, via piston mechanisms 60, which permit the rails 56 to be raised in the Z-direction relative to the clatter bars 55 when engaged by the underlying cradle structure 54, as will be described in more detail below.

A surround plate 57 is provided in the printing machine in a plane parallel to the X-Y plane shown, which is used to eliminate or at least reduce print medium smearing on the upper side of the stencil, and to protect the stencil from "coining" between the workpieces. The surround plate is mechanically adjustable (the adjustment mechanism is not shown for clarity) in the Z-direction to enable the relative heights of the multiple workpieces 35 against the height of the surround plate 57 to be optimised. The surround plate 57 comprises a plurality of apertures corresponding in size and position to the array of support members 10, and is located above the array and in registration thereto. In the preferred embodiment, the upper surface of the surround plate 57 is located at the printing height of the workpieces 35, so that, following lifting of the workpieces 35 to their print positions (described in more detail below), the upper surfaces of both the workpieces 35 and the surround plate 57 are almost co-planar (typically the surround plate 57 may be fractionally lower than the upper surface of the workpieces 35) to facilitate the printing process.

A pneumatic and electrical distribution box 58 is provided on the table 51, for distributing pneumatic and electrical power, and communications signals, such as electrical control signals, to the support members 10 via associated lines (not shown for clarity). In particular, the pneumatic connection is operative to selectively apply an at least partial vacuum to the vacuum channel 33 and thus hold the respective workpiece 35 onto the support member 10, while the electrical lines are operative to supply electrical power to the actuation mechanism of each support member 10. The electrical and pneumatic supplies are controlled by a processor (not shown), for example a processor located within the printing machine, or an external processing means such as a laptop, PC or the like.

A lifting mechanism 59 is provided within the printing machine to raise the singulated workpieces 35 into a printing position. The lifting mechanism 59 comprises an actuator, which may for example by electrically or pneumatically driven, and operative to lift the cradle structure 54, and hence also lift the rails 56, which overlie the cradle structure 54, table 51, distribution box 58, reference plate 52, carrier 61, support members 10 and any overlying workpieces 35.

FIG. 5 schematically shows the lifting table of FIG. 4 with the surround plate 57 omitted for clarity. Here it can be seen that the workpieces 35 are located within carrier 61, which engages with rails 56. At the printing location, i.e. above the table 51, the carrier 61 is clamped by an edge clamp or "snugger" 62. This acts to fix the carrier 61 at the correct position in the Y-direction, as is known in the art. Carrier 61 includes a pattern of apertures which are sized so as to support respective workpieces 35 proximate the peripheries thereof, but to allow the workpieces 35 to move relative to the carrier parallel to the X-Y plane, in particular when the respective support member's actuation mechanism is driven.

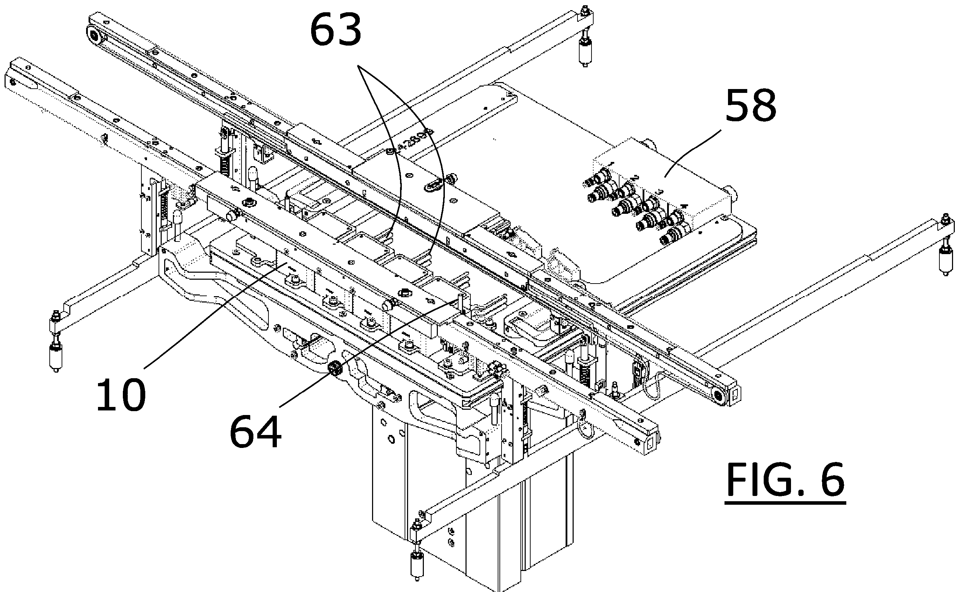

FIG. 6 schematically shows the lifting table of FIG. 5 with the carrier 61 omitted for clarity. Here, pneumatic and electrical connectors 63 can be seen, which provide power from the distribution box 58 to the respective support members 10. For clarity, the entirety of the connectors 63 are not shown. Also visible in FIG. 6 is a physical stop 64 which, as is known in the art, is a vertically drivable post which, when in a raised configuration, limits the movement of carrier 61 along the X-direction when driven by rails 56. Following printing, the physical stop 64 is lowered so that carrier 61 can be transported away from the printing position.

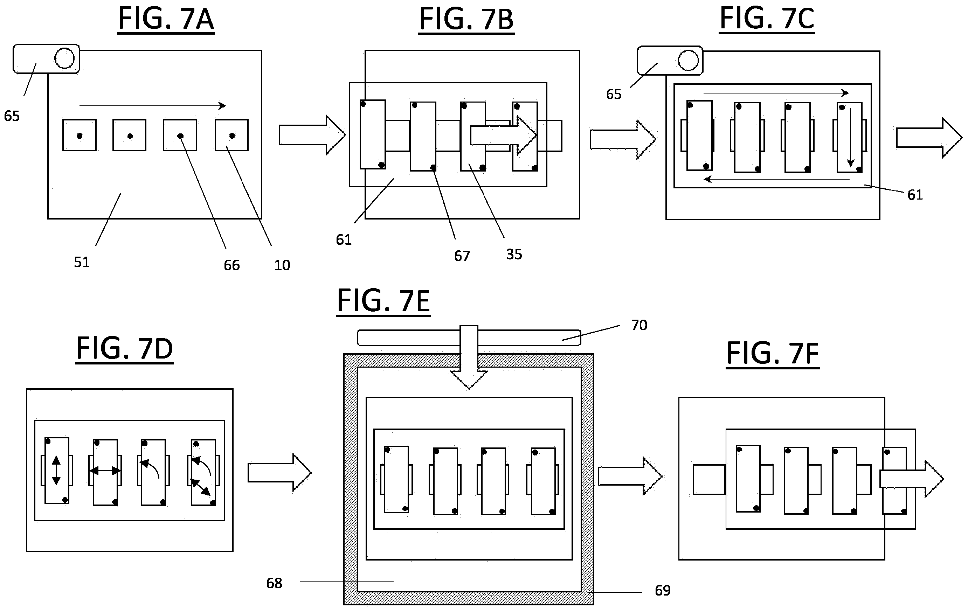

FIGs. 7A-F schematically show, from above, stages in a printing process in accordance with the present invention, using the apparatus of FIG. 4. It should be noted that for clarity, many components, including in particular the surround plate 57 (see FIG. 4), have been omitted.

FIG. 7A shows an initial product setup stage. A camera 65, preferably a moving camera, is used to scan the positions of the support members 10 at their "home" or neutral position, by imaging fiducials 66 provided on the support members, with the arrow showing a typical direction of scan. Typically, tooling modules 30 (see FIG. 2C) are fitted to each support member 10 after this scanning stage. Alternatively, the support members may have tooling modules fitted prior to scanning, in which case the fiducials 66 may be located on the tooling modules. Similar fiducials will also be scanned on the stencil (not shown) to be used, either by the same camera 65 or by a dedicated camera (not shown), in which latter case the scanning of the support members and stencil may be performed simultaneously or near simultaneously. Once the relative positions of the support members and stencil are determined, a gross alignment of the stencil to the support members 10 is performed, typically by moving the stencil, as is known in the art. Alternatively or additionally, the position of the support assembly or table 51 may be adjusted.

FIG. 7B shows workpieces 35 entering the printing machine on carrier 61 (which for clarity is shown transparently), being driven by the rails 56 (see FIG. 4). The workpieces 35 are each provided with workpiece fiducials 67.

In FIG. 7C, once the carrier 61 is in printing position, as controlled by the physical stop 64 (see FIG. 6), the workpieces 35 are lifted from the carrier 61 by raising the lifting mechanism 59 (see FIG. 4) and hence the table 51 and support members 10 into contact with the undersides of the workpieces 35. A vacuum or partial vacuum is applied to the support members 10 to clamp the workpieces 35 onto their respective chucks 31 (see FIG. 2C for example) of support members 10. With the workpieces 35 lifted to a "vision height", which could be equal to, higher or lower than their printing height depending on the camera set-up, the camera 65 scans all workpiece fiducials 67. The arrows show a suitable direction of scan.

In FIG. 7D, the support members 10 are aligned, based on the positions of the fiducials 67 determined in the previous step, by suitable operation of the respective support member actuation mechanisms. For example only, the left-most workpiece is shown as being repositioned in the Y-direction, the next workpiece is shown as being repositioned in the X-direction, the third workpiece is shown as being repositioned in θ about an axis parallel to the Z-axis, and the fourth workpiece is shown as being repositioned in a superposition of X, Y and θ movements. The alignment is controlled by the processor using the encoder provided on the head unit or base of each support member 10. The support members 10 may be aligned either sequentially or simultaneously. Assuming the movement of the support members can be accurately controlled, no further scanning is required. However, in alternative embodiments a further scan, post-alignment, may be performed to confirm correct alignment and instigate an alignment correction process if required. Following alignment, the workpieces are moved to their printing height, and in-line with the surround plate 57 (see FIG. 4).

FIG. 7E schematically shows a printing process, in which a stencil 68, supported within a frame 69, is engaged by a squeegee 70 to push print medium such as solder paste through the stencil aperture pattern and onto the workpieces. The arrow shows the direction of squeegee movement.

Following printing, the workpieces 35 may then be returned to their transport height in which they engage the carrier 61, while the support members 10 lower out of the path of the carrier 61. They may be returned to their home or neutral positions before or during this lowering. Vacuum will be retained until the workpiece is returned to its home position and returned gently to the dowels within the carrier 61. In other words, when "transport height" is reached the vacuum clamping will be switched off.

FIG. 7F schematically shows the carrier 61 and workpieces 35 leaving the printing machine.

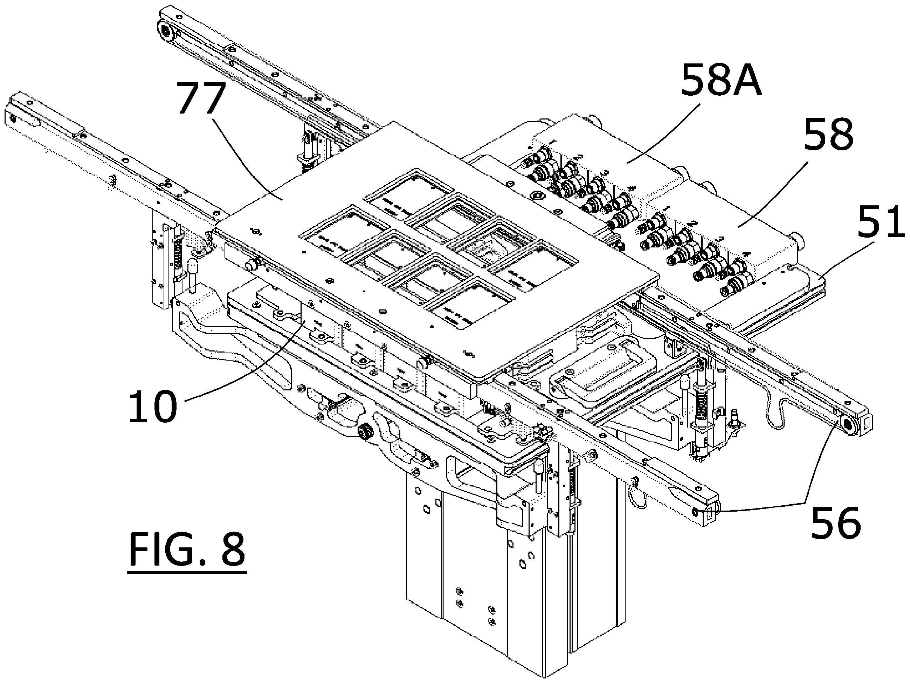

The embodiments described in respect of FIGs. 4 to 7 all use a 4x1 array of support members. However, the present invention is equally applicable to other size arrays of two or more support members, e.g. 2x1 or 1x2, 2x2, 3x2, 2x3, 3x3 etc. By way of example, FIG. 8 schematically shows, in perspective view, the lifting table of FIG. 4 fitted with a workpiece support assembly in accordance with an alternative embodiment of the present invention, having a 4x2 array of workpiece support modules. This embodiment is very similar to that shown in FIG. 4, and so need not be described in great detail. For clarity, it should be noted that the clatter bars are omitted from FIG. 8.

In this embodiment, the workpiece support assembly comprises two rows of four support members 10. Naturally, a surround plate 77 now includes eight apertures which overlie the respective support members 10. The carrier (not visible in FIG. 8) will also be adapted to carry eight workpieces in two rows of four. It can be seen that rails 56 have been moved further apart than shown in In order to provide the required pneumatic and electrical power to the support members, two distribution boxes 58, 58A are provided, one for each row of support members 10. Conveniently, with this arrangement, when it is desired to change the printing machine set-up from a 4×1 array (as in FIG. 4) to a 4x2 array, it is necessary merely to add an additional distribution box 58A. Of course, the distribution box 58A may optionally be permanently provided on the table 51, so that different support assembly configurations may be implemented with the minimum of effort.

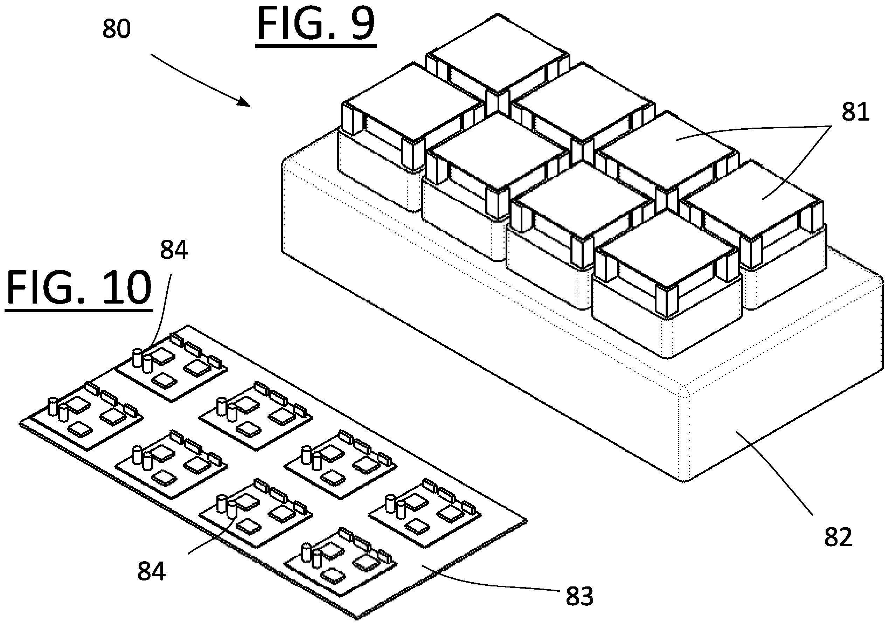

FIG. 9 schematically shows, in perspective view, a workpiece support assembly 80 in accordance with an alternative embodiment of the present invention, while FIG. 10 schematically shows, in perspective view, a composite control board for use with the workpiece support assembly of FIG. 9. In the previously-described embodiments, each support member was provided with its own respective and individual control board for controlling the actuation mechanism of that support member. Such an arrangement is advantageous in that, for example, if a control board fails, then it may be easily replaced. However, for some applications, it may be preferable to make use of support members which are located closer together, i.e. they have a higher packing density. The workpiece support assembly 80 includes a plurality, here eight, support members 81, which are relatively closely packed. Each support member is retained on a common assembly unit 82. In this embodiment, rather than providing each support member with its own control board, a single, common or composite control board 83 (see FIG. 10) is provided in the common assembly unit 82, directly below the support members 81. The composite control board 83 includes separate processor circuitry 84 for each respective support member 81, and which is operable to control the actuation mechanism within each support member 81. It may be seen that the support members 81 are somewhat shorter than those shown in the previous embodiments, since they no longer include dedicated control boards. Otherwise, the operation of the workpiece support assembly 80 is similar to that described with reference to the preceding embodiments.

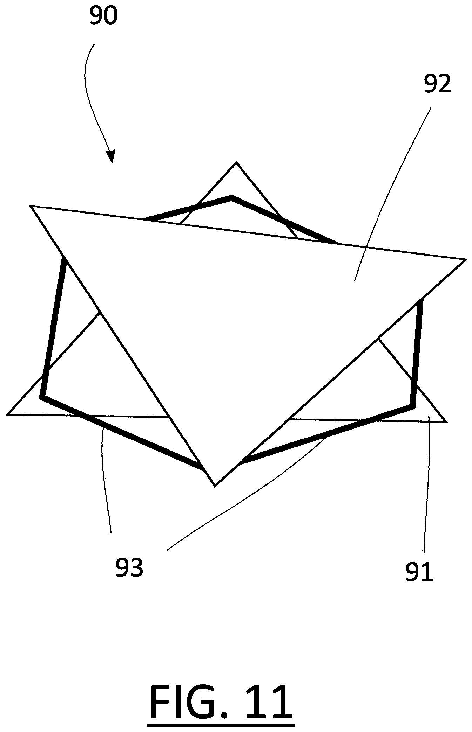

Other forms of parallel kinematic actuation mechanism may be used within each support member. FIG. 11 for example schematically shows a hexapod-type actuation mechanism 90 (also known as a Stewart or Stewart-Gough platform). Here, a stator 91 is shown as being connected to a rotor 92 via a plurality of discrete drive units in the form of linearly actuable pistons 93, as is generally known in the art. By individually controlling the extension of each piston 93, the X, Y and θ position of the rotor 92 may be fully controlled relative to the stator 91.

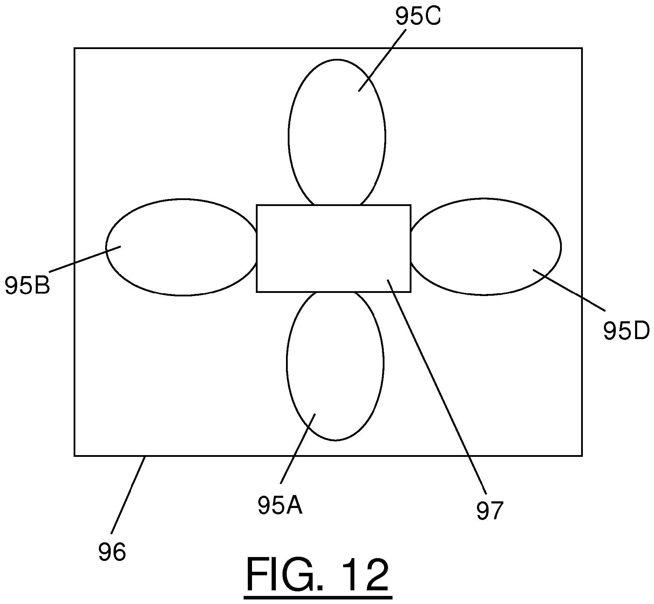

FIG. 12 schematically shows, from above, an actuation mechanism in accordance with a further embodiment. Here, an array of four drive units, each comprising a coil 95A-D, is provided on a base 96. The coil 95A-D of each drive unit is wound about a respective winding axis, the winding axes being parallel to each other and orthogonal to the plane in which the head unit (not shown) moves in use. With such an arrangement, at least two of the drive units (here coils 95A and 95C) may be spaced in a first direction parallel to the plane, and at least two of the drive units (here coils 95B and 95C) spaced in a second direction parallel to the plane, the first and second directions being orthogonal. In this configuration, full translational and rotational control of the head unit is possible. A control board 97 is shown located at the centre of the drive unit array, which is connected to each coil 95A-D and operable to control the coils.

The above-described embodiments are exemplary only, and other possibilities and alternatives within the scope of the invention will be apparent to those skilled in the art. For example, the actuation mechanism may comprise alternative forms of parallel kinematic systems.

While the above-described embodiments utilise a particular lifting table mechanism to move the workpieces into the printing position using clatter bars as a mechanical stop, other arrangements are equally possible, for example using one or more motors, for example linear motors, to achieve a fully-controlled lifting motion.

### Reference numerals used:

1, 2, 3 - Panels
1a-3d - Boards
10 - Support member
11 - Head unit
12 - Base
13 - Stator
14 - Rotor
15 - Linear motor coils
16 - Control boards
17 - Housing
18, 19 - Air bearings
20 - Tooling interface plate
21 - Posts
22 - Aperture
23 - Encoder
30 - Tooling module
31 - Tooling chuck
32 - Vacuum engagement opening
33 - Vacuum channel
35, 35A - Singulated workpiece
40 - Actuation mechanism
41 - Actuators
42 - Rotor
43 - Surfaces
50 - Support apparatus
51 - Table
52 - Reference plate
53 - Attachment points
54 - Cradle structure
55 - Clatter bars
56 - Rails
57 - Surround plate
58 - Distribution box
59 - Lifting mechanism
60 - Piston mechanism
61 - Carrier
62 - Edge clamp
63 - Pneumatic / electrical connectors
64 - Physical stop
65 - Camera
66 - Support member fiducial
67 - Workpiece fiducial
68 - Stencil
69 - Stencil frame
70 - Squeegee
77 - Surround plate
78, 78A - Distribution boxes
80 - Workpiece support assembly
81 - Support member
82 - Assembly unit
83 - Composite control board
84 - Circuitry
90 - Hexapod-type actuation mechanism
91 - Stator
92 - Rotor
93 - Piston
95A-D - Coils
96 - Base
97 - Control board

## Claims

1. A workpiece support assembly for supporting and aligning a plurality of singulated workpieces (35) in a printing operation, the workpiece support assembly comprising an assembly body (51, 52) and a plurality of support members (10) mounted on the assembly body (51, 52) which each support a workpiece (35) in use, each support member (10) comprising:
a base (12) mounted on the assembly body (51, 52), and
a head unit (11) for supporting a workpiece (35) thereon,
**characterised in that** each support member (10) further comprises an actuation mechanism for moving the head unit (11) relative to the base (12),
wherein the actuation mechanism comprises a parallel kinematic system having at least three drive units (15, 41, 93, 95A-D) each directly acting on the head unit (11), such that the actuation mechanism is selectively operative to move the head unit (11) relative to the base (12) to cause a translation of the head unit (11) parallel to a plane, a rotation of the head unit (11) about an axis orthogonal to that plane, or a combination of said translation and said rotation.

2. The workpiece support assembly of claim 1, wherein each drive unit comprises a coil (15, 95A-D).

3. The workpiece support assembly of claim 2, wherein each drive unit comprises a linear motor coil (15, 95A-D); optionally the actuation mechanism comprises three drive units, the linear motor coils (15) of said drive units have non-parallel axes.

4. The workpiece support assembly of claim 2, wherein the coil (15, 95A-D) of each drive unit is wound about a respective winding axis, the winding axes being parallel to each other and orthogonal to the plane.

5. The workpiece support assembly of claim 4, wherein the actuation mechanism comprises four drive units (95A-D), with at least two of said drive units (95A, C) spaced in a first direction parallel to the plane, and at least two of said drive units (95B, D) spaced in a second direction parallel to the plane, the first and second directions being orthogonal.

6. The workpiece support assembly of any preceding claim, wherein the drive units (15, 41, 93, 95A-D) are mounted to the base (12).

7. The workpiece support assembly of any preceding claim, wherein the support member (10) comprises a bearing, optionally an air bearing (18, 19), located between the base (12) and the head unit (11).

8. The workpiece support assembly of claim 1, wherein the actuation mechanism comprises a hexapod (90).

9. The workpiece support assembly of any preceding claim, comprising a processor for controlling the actuation mechanism.

10. The workpiece support assembly of any preceding claim, wherein at least one of the head unit (11) and base (12) comprises at least one encoder (23) which is operative to determine a position of the head unit (11).

11. The workpiece support assembly of any preceding claim, wherein the head unit (11) comprises a tooling interface for receiving a tooling module (30), the tooling module (30) supporting a workpiece (35) thereon in use; optionally the workpiece (35) is supported parallel to the plane in use.

12. The workpiece support assembly of any preceding claim, wherein the base (12) comprises a port for connection to a vacuum source, the head unit (11) comprises an aperture (22), and the support member (10) comprises a vacuum path extending between the port and the aperture (22); optionally the vacuum path comprises flexible tubing.

13. The workpiece support assembly of any preceding claim, which is adapted for removable engagement with a printing machine.

14. A printing machine comprising the workpiece support assembly of any preceding claim.

15. A method of printing a plurality of singulated workpieces (35), comprising the steps of:
providing the printing machine of claim 14;
aligning the plurality of singulated workpieces (35) using a method comprising the steps of:
a) positioning the workpieces (35) over the workpiece support assembly of any of claims 1 to 13, such that each workpiece (35) overlies a respective support member (10);
b) lifting the workpiece support assembly so that the support members (10) contact and lift the respective overlying workpieces (35); and
c) aligning each workpiece (35) individually by operation of the respective actuation mechanisms; and
performing a printing operation on the aligned workpieces (35).

16. The method of claim 15, wherein each workpiece (35) comprises a fiducial marking (67), step a) comprises optically detecting each fiducial (67) to determine the orientation and position of the workpieces (35), and step c) comprises aligning each workpiece (35) individually to a predetermined position by operation of the respective actuation mechanisms in dependence of the determined orientation and position.

17. The method of either of claims 15 and 16, comprising an initial step of placing a plurality of workpieces (35) into a carrier (61), the carrier (61) supporting a peripheral region of each workpiece (35) (and having an aperture proximate a central portion of each workpiece), and wherein step a) comprises positioning the carrier (61) over the workpiece support assembly, such that each workpiece (35) overlies a respective support member (10), wherein step b) comprises lifting the workpiece support assembly so that the support members (10) contact and lift the respective overlying workpieces (35) away from the carrier (61), and, following completion of the printing operation, the workpieces (35) are lowered into engagement with the carrier (61), and the carrier (61) is transported from the printing machine.

## Patentansprüche

1. Werkstückträgerbaugruppe zum Tragen und Ausrichten einer Vielzahl von einzeln getrennten Werkstücken (35) in einem Druckvorgang, wobei die Werkstückträgerbaugruppe einen Baugruppenkörper (51, 52) und eine Vielzahl von an dem Baugruppenkörper (51, 52) angebrachten Trägerelementen (10) umfasst, die in Verwendung jeweils ein Werkstück (35) tragen, wobei jedes Trägerelement (10) Folgendes umfasst:
eine auf dem Baugruppenkörper (51, 52) angebrachte Basis (12), und
eine Kopfeinheit (11) zum Tragen eines Werkstücks (35) darauf,
**gekennzeichnet dadurch, dass** jedes Trägerelement (10) ferner einen Betätigungsmechanismus zum Bewegen der Kopfeinheit (11) relativ zu der Basis (12) umfasst,
wobei der Betätigungsmechanismus ein paralleles kinematisches System umfasst, das mindestens drei Antriebseinheiten (15, 41, 93, 95A-D) aufweist, die jeweils auf eine Weise direkt auf die Kopfeinheit (11) wirken, dass der Betätigungsmechanismus selektiv betriebsfähig ist, um die Kopfeinheit (11) relativ zu der Basis (12) zu bewegen, um eine Übertragung der Kopfeinheit (11) parallel zu einer Ebene, eine Drehung der Kopfeinheit (11) um eine zu dieser Ebene orthogonalen Achse oder eine Kombination aus der Übertragung und der Drehung zu veranlassen.

2. Werkstückträgerbaugruppe nach Anspruch 1, wobei jede Antriebseinheit eine Spule (15, 95A-D) umfasst.

3. Werkstückträgerbaugruppe nach Anspruch 2, wobei jede Antriebseinheit eine Linearmotorspule (15, 95A-D) umfasst; wobei optional der Betätigungsmechanismus drei Antriebseinheiten umfasst, wobei die Linearmotorspulen (15) der Antriebseinheiten nicht parallele Achsen aufweisen.

4. Werkstückträgerbaugruppe nach Anspruch 2, wobei die Spule (15, 95A-D) jeder Antriebseinheit um eine jeweilige Windungsachse gewunden ist, wobei die Windungsachsen parallel zueinander und orthogonal zu der Ebene sind.

5. Werkstückträgerbaugruppe nach Anspruch 4, wobei der Betätigungsmechanismus vier Antriebseinheiten (95A-D) umfasst, wobei mindestens zwei der Antriebseinheiten (95A, C) in eine erste Richtung parallel zu der Ebene beabstandet sind, und mindestens zwei der Antriebseinheiten (95B, D) in eine zweite Richtung parallel zu der Ebene beabstandet sind, wobei die erste und die zweite Richtung orthogonal sind.

6. Werkstückträgerbaugruppe nach einem der vorhergehenden Ansprüche, wobei die Antriebseinheiten (15, 41, 93, 95A-D) an der Basis (12) angebracht sind.

7. Werkstückträgerbaugruppe nach einem der vorhergehenden Ansprüche, wobei das Trägerelement (10) ein Lager, optional ein Luftlager (18, 19), umfasst, das sich zwischen der Basis (12) und der Kopfeinheit (11) befindet.

8. Werkstückträgerbaugruppe nach Anspruch 1, wobei der Betätigungsmechanismus ein Hexapod (90) umfasst.

9. Werkstückträgerbaugruppe nach einem der vorhergehenden Ansprüche, umfassend einen Prozessor zum Steuern des Betätigungsmechanismus.

10. Werkstückträgerbaugruppe nach einem der vorhergehenden Ansprüche, wobei mindestens eine aus der Kopfeinheit (11) und der Basis (12) mindestens einen Drehgeber (23) umfasst, der dazu betriebsfähig ist, eine Position der Kopfeinheit (11) zu bestimmen.

11. Werkstückträgerbaugruppe nach einem der vorhergehenden Ansprüche, wobei die Kopfeinheit (11) eine Werkzeugschnittstelle zum Empfangen eines Werkzeugmoduls (30) umfasst, wobei das Werkzeugmodul (30) in Verwendung darauf ein Werkstück (35) trägt; wobei optional das Werkstück (35) in Verwendung parallel zu der Ebene getragen wird.

12. Werkstückträgerbaugruppe nach einem der vorhergehenden Ansprüche, wobei die Basis (12) einen Anschluss zur Verbindung mit einer Vakuumquelle, die Kopfeinheit (11) eine Öffnung (22) und das Trägerelement (10) einen Vakuumpfad umfasst, der sich zwischen dem Anschluss und der Öffnung (22) erstreckt; wobei optional der Vakuumpfad eine flexible Leitung umfasst.

13. Werkstückträgerbaugruppe nach einem der vorhergehenden Ansprüche, die zum abnehmbaren Einrasten in eine Druckmaschine angepasst ist.

14. Druckmaschine, umfassend die Werkstückträgerbaugruppe nach einem der vorhergehenden Ansprüche.

15. Verfahren zum Drucken einer Vielzahl von einzeln getrennten Werkstücken (35), die folgenden Schritte umfassend:
Bereitstellen der Druckmaschine nach Anspruch 14;
Ausrichten der Vielzahl von einzeln getrennten Werkstücken (35), unter Verwendung eines Verfahrens, das die folgenden Schritte umfasst:
a) Positionieren des Werkstücks (35) über der Werkstückträgerbaugruppe nach einem der Ansprüche 1 bis 13 auf eine Weise, dass jedes Werkstück (35) über einem jeweiligen Trägerelement (10) liegt;
b) Anheben der Werkstückträgerbaugruppe, sodass die Trägerelemente (10) in Kontakt mit den jeweiligen darüber liegenden Werkstücken (35) sind und diese anheben; und
c) Individuelles Ausrichten jedes Werkstücks (35) durch Bedienen der jeweiligen Betätigungsmechanismen; und
Durchführen eines Druckvorgangs auf den ausgerichteten Werkstücken (35).

16. Verfahren nach Anspruch 15, wobei jedes Werkstück (35) eine Bezugsmarkierung (67) umfasst, Schritt a) das optische Erkennen jedes Bezugs (67) umfasst, um die Orientierung und Position der Werkstücke (35) zu bestimmen, und Schritt c) das Ausrichten jedes Werkstücks (35) individuell an einer vorherbestimmten Position durch Bedienen der jeweiligen Betätigungsmechanismen abhängig von der bestimmten Orientierung und Position umfasst.

17. Verfahren nach einem der Ansprüche 15 oder 16, umfassend einen Anfangsschritt des Platzierens einer Vielzahl von Werkstücken (35) in einer Beförderungsvorrichtung (61), wobei die Beförderungsvorrichtung (61) eine Umfangsregion jedes Werkstücks (35) trägt (und eine Öffnung nahe zu einem zentralen Abschnitt jedes Werkstücks aufweist), und wobei Schritt a) das Positionieren der Beförderungsvorrichtung (61) über der Werkstückträgerbaugruppe auf eine Weise umfasst, dass jedes Werkstück (35) über einem jeweiligen Trägerelement (10) liegt, wobei Schritt b) das Anheben der Werkstückträgerbaugruppe umfasst, sodass die Trägerelemente (10) mit den jeweiligen darüber liegenden Werkstücken (35) in Kontakt sind und diese von der Beförderungsvorrichtung (61) weg anheben, und im Anschluss an die Durchführung des Druckvorgangs die Werkstücke (35) in eine Einrastung mit der Beförderungsvorrichtung (61) abgesenkt werden und die Beförderungsvorrichtung (61) von der Druckmaschine abtransportiert wird.

## Revendications

1. Ensemble de support de pièce pour soutenir et aligner une pluralité de pièces (35) individuelles lors d'une opération d'impression, l'ensemble de support de pièce comprenant un corps d'assemblage (51, 52) et une pluralité d'éléments de support (10) montés sur le corps d'assemblage (51, 52), dont chacun supporte une pièce (35) en cours d'utilisation, chaque élément de support (10) comprenant :
une base (12) montée sur le corps d'assemblage (51, 52), et
une unité de tête (11) pour soutenir une pièce (35) sur celle-ci,
**caractérisé en ce que** chaque élément de support (10) comprend en outre un mécanisme d'actionnement pour déplacer l'unité de tête (11) par rapport à la base (12),
dans lequel le mécanisme d'actionnement comprend un système cinématique parallèle ayant au moins trois unités d'entraînement (15, 41, 93, 95A-D) chacune agissant directement sur l'unité de tête (11), de sorte que le mécanisme d'actionnement est sélectivement opérationnel pour déplacer l'unité de tête (11) par rapport à la base (12) afin de provoquer une translation de l'unité de tête (11) parallèlement à un plan, une rotation de l'unité de tête (11) autour d'un axe orthogonal à ce plan, ou une combinaison de ladite translation et de ladite rotation.

2. Ensemble de support de pièce de la revendication 1, dans lequel chaque unité d'entraînement comprend une bobine (15, 95A-D).

3. Ensemble de support de pièce de la revendication 2, dans lequel chaque unité d'entraînement comprend une bobine de moteur linéaire (15, 95A-D) ; éventuellement, le mécanisme d'actionnement comprend trois unités d'entraînement, les bobines de moteur linéaire (15) desdites unités d'entraînement ayant des axes non parallèles.

4. Ensemble de support de pièce de la revendication 2, dans lequel la bobine (15, 95A-D) de chaque unité d'entraînement est enroulée autour d'un axe d'enroulement respectif, les axes d'enroulement étant parallèles les uns aux autres et orthogonaux au plan.

5. Ensemble de support de pièce de la revendication 4, dans lequel le mécanisme d'actionnement comprend quatre unités d'entraînement (95A-D), avec au moins deux desdites unités d'entraînement (95A, C) espacées dans une première direction parallèle au plan, et au moins deux desdites unités d'entraînement (95B, D) espacées dans une deuxième direction parallèle au plan, la première et la deuxième direction étant orthogonales.

6. Ensemble de support de pièce de l'une quelconque des revendications précédentes, dans lequel les unités d'entraînement (15, 41, 93, 95A-D) sont montées sur la base (12).

7. Ensemble de support de pièce de l'une quelconque des revendications précédentes, dans lequel l'élément de support (10) comprend un palier, éventuellement un palier à air (18, 19), situé entre la base (12) et l'unité de tête (11).

8. Ensemble de support de pièce de la revendication 1, dans lequel le mécanisme d'actionnement comprend un hexapode (90).

9. Ensemble de support de pièce de l'une quelconque des revendications précédentes, comprenant un processeur pour contrôler le mécanisme d'actionnement.

10. Ensemble de support de pièce de l'une quelconque des revendications précédentes, dans lequel au moins l'une des unités de tête (11) et de base (12) comprend au moins un codeur (23) qui est opérationnel pour déterminer la position de l'unité de tête (11).

11. Ensemble de support de pièce de l'une quelconque des revendications précédentes, dans lequel l'unité de tête (11) comprend une interface d'outillage pour recevoir un module d'outillage (30), le module d'outillage (30) soutenant une pièce (35) sur celle-ci en cours d'utilisation ; éventuellement, la pièce (35) est soutenue parallèlement au plan en cours d'utilisation.

12. Ensemble de support de pièce de l'une quelconque des revendications précédentes, dans lequel la base (12) comprend un port pour la connexion à une source de vide, l'unité de tête (11) comprend une ouverture (22), et l'élément de support (10) comprend un conduit de vide s'étendant entre le port et l'ouverture (22) ; éventuellement, le conduit de vide comprend un tuyau flexible.

13. Ensemble de support de pièce de l'une quelconque des revendications précédentes, lequel est conçu pour un engagement amovible avec une machine d'impression.

14. Machine d'impression comprenant l'ensemble de support de pièce de l'une quelconque des revendications précédentes.

15. Procédé d'impression d'une pluralité de pièces (35) individuelles, comprenant les étapes de :
fourniture de la machine d'impression de la revendication 14 ;
alignement de la pluralité de pièces (35) individuelles à l'aide d'un procédé comprenant les étapes de :
a) positionnement des pièces (35) au-dessus de l'ensemble de support de pièce de l'une quelconque des revendications 1 à 13, de sorte que chaque pièce (35) repose au-dessus d'un élément de support (10) respectif ;
b) soulèvement de l'ensemble de support de pièce de manière à ce que les éléments de support (10) entrent en contact avec les pièces (35) respectives reposant au-dessus et les soulèvent ; et
c) alignement de chaque pièce (35) individuellement par l'action des mécanismes d'actionnement respectifs ; et
mise en œuvre d'une opération d'impression sur les pièces (35) alignées.

16. Procédé de la revendication 15, dans lequel chaque pièce (35) comprend un marquage de repère (67), l'étape a) comprend la détection optique de chaque repère (67) pour déterminer l'orientation et la position des pièces (35), et l'étape c) comprend l'alignement de chaque pièce (35) individuellement à une position prédéterminée par l'action des mécanismes d'actionnement respectifs en fonction de l'orientation et de la position déterminées.

17. Procédé de l'une quelconque des revendications 15 et 16, comprenant une étape initiale de placement d'une pluralité de pièces (35) dans un porte-pièces (61), le porte-pièces (61) soutenant une région périphérique de chaque pièce (35) (et ayant une ouverture à proximité d'une partie centrale de chaque pièce), et dans laquelle l'étape a) comprend le positionnement du porte-pièces (61) au-dessus de l'ensemble de support de pièce, de sorte que chaque pièce (35) repose au-dessus d'un élément de support (10) respectif, dans lequel l'étape b) comprend le soulèvement de l'ensemble de support de pièce de manière à ce que les éléments de support (10) entrent en contact avec les pièces (35) respectives reposant au-dessus et les soulèvent hors du porte-pièces (61), et, après la réalisation de l'opération d'impression, les pièces (35) sont abaissées pour s'engager avec le porte-pièces (61), et le porte-pièces (61) est transporté hors de la machine d'impression.
